(19)

Europäisches Patentamt
European Patent Office
Office européen des brevets

(11) **EP 4 521 619 A1**

(12) **EUROPEAN PATENT APPLICATION**

(43) Date of publication:
**12.03.2025 Bulletin 2025/11**

(21) Application number: **23196322.4**

(22) Date of filing: **08.09.2023**

(51) International Patent Classification (IPC):
**H02M 1/32** (2007.01)   **H02M 3/00** (2006.01)
**H02M 3/335** (2006.01)

(52) Cooperative Patent Classification (CPC):
**H02M 1/325; H02M 3/01; H02M 3/33571;**
H02M 1/32

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **NXP USA, Inc.
Austin TX 78735 (US)**

(72) Inventors:
• **Degen, Peter Theodorus Johannes
Eindhoven (NL)**
• **Langeslag, Wilhelmus Hinderikus Maria
Eindhoven (NL)**

(74) Representative: **Hardingham, Christopher Mark
NXP Semiconductors
Intellectual Property Group
Abbey House
25 Clarendon Road
Redhill, Surrey RH1 1QZ (GB)**

(54) **CONTROLLER**

(57)    A controller for a switched mode power supply comprising a primary winding configured to receive an input voltage at a first terminal of the primary winding. A first capacitor is coupled in series between a second terminal of the primary winding and a reference terminal configured to be coupled to a reference voltage. A secondary winding is configured to provide an output voltage of the SMPS based on the input voltage and an auxiliary winding is inductively coupled to one or both of the primary winding and the secondary winding and is configured to provide an auxiliary voltage based at least on a voltage of the first capacitor. The controller is configured to output an overvoltage signal indicative of an overvoltage across the first capacitor, based on a comparison of the auxiliary voltage during a primary stroke of the SMPS to a threshold indicative of a predetermined maximum first capacitor voltage.

Figure 3

EP 4 521 619 A1

**Description**

**Field**

The present disclosure relates to a controller for a switched mode power supply and to a switched mode power supply comprising said controller. The disclosure also relates to a method of operating said controller.

**Background**

It is known to use a switched mode power supply (SMPS) in power adapters to convert the mains voltage into a lower voltage which is appropriate for a given application. A well know example is the power adapter for a mobile phone, a laptop, or a tablet etc.

During the operation of a SMPS, a primary capacitor is charged. The output voltage can be based on the voltage on the primary capacitor. As with most electronic components (such as semiconductor based components) the primary capacitor has a maximum rated voltage. It is important to ensure that the primary capacitor does not experience an overvoltage where it exceeds a desired maximum voltage or its maximum rated voltage. However, determining when the voltage on the primary capacitor is in an overvoltage condition can be challenging.

**Summary**

According to a first aspect of the present disclosure there is provided a controller for a switched mode power supply, SMPS, the SMPS comprising a primary winding configured to receive an input voltage (Vin) at a first terminal of the primary winding; a first capacitor coupled in series between a second terminal of the primary winding and a reference terminal configured to be coupled to a reference voltage; and a secondary winding configured to provide an output voltage of the SMPS based on the input voltage; and an auxiliary winding inductively coupled to one or both of the primary winding and the secondary winding and configured to provide an auxiliary voltage (Vaux) based at least on a voltage of the first capacitor ($V_{CR}$);

wherein the controller is configured to output an overvoltage signal indicative of an overvoltage across the first capacitor, based on a comparison of the auxiliary voltage during a primary stroke of the SMPS to a threshold indicative of a predetermined maximum first capacitor voltage ($V_{CR\_max}$).

In one or more embodiments said comparison comprises a comparison between the threshold and a difference between the input voltage and the auxiliary voltage.

In one or more examples the voltage of the first capacitor ($V_{CR}$) is related to the input voltage (Vin) minus the auxiliary voltage (Vaux).

In one or more examples when the polarity of the auxiliary winding is reversed, the voltage of the first capacitor ($V_{CR}$) is related to the auxiliary voltage (Vaux) minus the input voltage (Vin).

In one or more examples the predetermined maximum first capacitor voltage ($V_{CR\_max}$) is an analogue signal comprising the predetermined maximum capacitor voltage or a signal representative of the predetermined maximum capacitor voltage or a digital signal representative of the predetermined maximum capacitor voltage.

In one or more embodiments the controller is configured to, in response to the overvoltage signal, control the SMPS to stop charging the first capacitor.

In one or more embodiments the controller is thereby configured to control the duration for which the first capacitor is charged during each primary stroke based at least in part on the overvoltage signal.

In one or more examples the controller, in response to the overvoltage signal, is configured to continue to provide the output voltage of the SMPS.

In one or more embodiments the controller comprises:

a first input terminal configured to receive a first voltage indicative of the input voltage;
a second input terminal configured to receive a second voltage indicative of the auxiliary voltage; and
a comparator configured to receive a first signal indicative of the first voltage, and a second signal indicative of the second voltage, wherein the comparator is further configured to output the overvoltage signal indicative of an overvoltage across the first capacitor based on a difference between the second signal and the first signal during the primary stroke of the SMPS and the threshold indicative of the predetermined maximum first capacitor voltage ($V_{CR\_max}$).

In one or more embodiments the first signal is based on a difference between the first voltage and the threshold indicative of the predetermined maximum first capacitor voltage ($V_{CR\_max}$).

In one or more examples the first signal may be derived from the first voltage and may have one or more arithmetic operations performed on the first voltage before being provided to the first input terminal of the comparator.

In one or more examples the second signal may be derived from the second voltage and may have one or more arithmetic operations performed on the second voltage before being provided to the second input terminal of the comparator.

In one or more examples both the first signal and second signal may be derived from the first voltage and second voltage respectively and may each have one or more arithmetic operations performed on the first voltage and second voltage before being provided to the first input terminal and the second input terminal of the comparator respectively.

In one or more embodiments the comparator is configured to output the overvoltage signal when the second signal is exceeds the first signal. In some embodiments, depending on the polarity of the auxiliary winding, the overvoltage signal may be generated when the second signal is greater than the first signal and in other embodiments the overvoltage signal may be generated when the second signal is lower than the first signal.

In one or more examples, the first signal and second signal are in the digital domain such that the first signal is a digital representation of the first voltage and the second signal is a digital representation of the second voltage.

In one or more embodiments the controller is configured to, in response to the output of the overvoltage signal, shorten the duration of the primary stroke to thereby limit the voltage to which the first capacitor is charged during one or more subsequent primary strokes of the SMPS.

In one or more embodiments the controller includes a difference element, wherein the difference element is configured to generate the first signal based on a third signal that is indicative of the first voltage minus the predetermined maximum first capacitor voltage.

In one or more examples, the comparison is made based on the auxiliary voltage present on the auxiliary winding only during the primary stroke. In other examples, the comparison is made based on the auxiliary voltage present on the auxiliary winding only during the primary stroke and an initial portion of the secondary stroke.

In one or more examples the controller is configured not to output the overvoltage signal during a secondary stroke of the SMPS.

In one or more embodiments the controller is configured to receive the second voltage from a first voltage divider coupled in parallel across the auxiliary winding, wherein the first voltage divider comprises a first resistor having a resistance R1 and a second resistor having a resistance R2, wherein a first terminal of the first resistor is coupled to a first terminal of the auxiliary winding and a second terminal of the first resistor is coupled to a first node and a first terminal of the second resistor is coupled to the first node and wherein the second terminal of the second resistor is coupled to the reference terminal, and wherein the first node provides the second voltage upon which the second signal is based.

In one or more embodiments the controller is configured to receive the first voltage from a second voltage divider comprising:

a third resistor and a fourth resistor, wherein a first terminal of the third resistor is configured to receive the input voltage and a second terminal of the third resistor is coupled to a second node and a first terminal of the fourth resistor is coupled to the second node and wherein the second terminal of the fourth resistor is coupled to the reference terminal, and wherein the second node provides the first voltage upon which the first signal is based.

In one or more examples the third resistor has a resistance of $R_3$ and the fourth resistor has a resistance of $R_4$ and the input voltage has a voltage $V_{IN}$, wherein the first voltage, $V_{first}$ comprises:

$$V_{first} = \frac{R_4}{R_3 + R_4} \cdot V_{IN}$$

In one or more examples the primary winding has a first number of turns ($n_p$) and the auxiliary winding has a second number of turns ($n_a$), such that the second voltage, $V_{second}$, is provided by the following equation:

$$V_{Second} = \frac{R_2}{R_1+R_2} \cdot \frac{n_a}{n_p} \cdot (V_{IN} - V_{CR}),$$

which equals:

$$V_{Second} = \frac{R_2}{R_1+R_2} \cdot \frac{n_a}{n_p} \cdot \left(\frac{R_3+R_4}{R_4} \cdot V_{first} - V_{CR}\right),$$

such that the comparator determines when the second voltage, $V_{second}$, exceeds the predetermined maximum first capacitor voltage ($V_{CR\_max}$). In some examples the comparator may be configured to determine when the second voltage, $V_{second}$, drops below the predetermined maximum first capacitor voltage ($V_{CR\_max}$).

In one or more examples a maximum value of the second voltage is 10V.

In one or more examples an overvoltage across the first capacitor is determined when the value of the second voltage exceeds a predetermined threshold value, wherein the second voltage that is indicative of an overvoltage condition is given by:

$$V_{Second} = \frac{R_2}{R_1+R_2} \cdot \frac{n_a}{n_p} \cdot \left(\frac{R_3+R_4}{R_4} \cdot V_{first} - V_{CR\_max}\right).$$

In one or more examples, the maximum value of the second voltage is provided for the largest difference between the input voltage (Vin) and the first capacitor voltage ($V_{CR}$).

In one or more examples the maximum value of the second voltage is provided by the following:

$$V_{second\_max} = \frac{R_2}{R_1+R_2} \cdot \frac{n_a}{n_p} \cdot \left(V_{in-max} - V_{CR-min}\right).$$

In one or more examples the maximum input voltage is 400V and the lowest first capacitor voltage is 0V, and thereby the maximum second voltage is:

$$V_{second\_max} = \frac{R_2}{R_1 + R_2} \cdot \frac{n_a}{n_p} \cdot 400$$

In one or more embodiments the controller is configured to provide a first switching signal to control the primary stroke of the SMPS during which the first capacitor is charged and a second switching signal to control a secondary stroke of the SMPS during which the first capacitor is discharged.

According to a second aspect of the present disclosure there is provided a switched mode power supply, SMPS, comprising the controller of any preceding claim, the SMPS comprising:

the primary winding configured to receive an input voltage at the first terminal of the primary winding; and
the first capacitor coupled in series between the second terminal of the primary winding and the reference terminal;
the secondary winding configured to provide an output voltage of the SMPS based on the input voltage; and

the auxiliary winding configured to provide an auxiliary voltage based at least on the first capacitor voltage ($V_{CR}$).

In one or more embodiments the auxiliary winding is inductively coupled to one or both of the primary winding and the secondary winding such that during the primary stroke of the SMPS, the auxiliary voltage is based on the input voltage (Vin) minus the voltage on the first capacitor ($V_{CR}$).

In one or more examples the SMPS comprises an asymmetric half bridge, AHB, topology.

According to a third aspect of the present disclosure there is provided a method for controlling a switched mode power supply, SMPS, the SMPS comprising a primary winding configured to receive an input voltage (Vin) at a first terminal of the primary winding; a first capacitor coupled in series between a second terminal of the primary winding and a reference terminal configured to be coupled to a reference voltage; and a secondary winding configured to provide an output voltage of the SMPS based on the input voltage; and an auxiliary winding inductively coupled to one or both of the primary winding and the secondary winding and configured to provide an auxiliary voltage (Vaux) based at least on a voltage of the first capacitor ($V_{CR}$);
the method comprising:
comparing, by a controller of the SMPS, the auxiliary voltage during a primary stroke of the SMPS to a threshold indicative of a predetermined maximum first capacitor voltage ($V_{CR\_max}$); and
outputting by the controller of the SMPS, an overvoltage signal indicative of an overvoltage across the first capacitor based on said comparison.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

## Brief Description of the Drawings

One or more embodiments will now be described by way of example only with reference to the accompanying drawings in which:

Figure 1 shows an example embodiment of a controller for a SMPS;
Figure 2 shows representative waveforms indicative of the operation of a SMPS;
Figure 3 shows an example configuration of components within the controller of the SMPS according to a first embodiment;
Figure 4 shows a first configuration of the components within the controller according to a first example embodiment of the controller;
Figure 5 shows a second configuration of the components within the controller according to a second example embodiment of the controller;
Figure 6 shows a third configuration of the components within the controller according to a first example embodiment of the controller;
Figure 7 shows an alternative embodiment of a controller for a SMPS; and
Figure 8 outlines a method of operating the controller of figures 1 to 7.

## Detailed Description

One or more embodiments disclosed herein relate to a controller for a switched mode power supply. During a primary stroke of the power supply a first capacitor, also known as a resonant or primary capacitor, is charged. The energy stored in the primary capacitor is then converted to the output voltage via a secondary side of the power supply during a secondary stroke of the power supply.

The controller of the disclosure can be configured to avoid serious damage of the SMPS by preventing the voltage on the first capacitor from exceeding its maximum rated voltage or other desired maximum value - referred to herein as a predetermined maximum capacitor voltage. In some examples, the controller can be configured to limit the output power of the SMPS whilst maintaining the required voltage regulation in the event that the predetermined maximum capacitor voltage is exceeded. This can ensure the continued operation of the device to which the SMPS is coupled without the risk of damaging the SMPS.

During the secondary stroke, the output voltage is related to the voltage on the primary capacitor. The proposed controller provides a way to identify an overvoltage condition on the primary capacitor during the primary stroke. One or more embodiments of the controller of the disclosure are advantageous as the controller may be applied to any type of switched mode power supply such as a fly back converter, or a buck-boost type converter. Further, one or more embodiments of the disclosed controller can achieve the desired control without requiring any additional components and without the addition of a dedicated pin on an integrated circuit (IC) that embodies the controller.

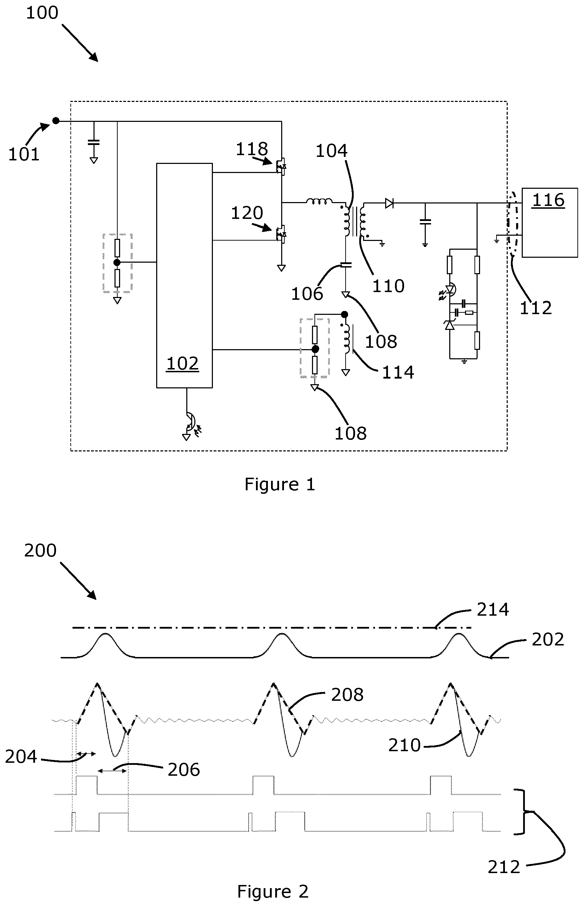

Figure 1 and figure 2 show an example of a SMPS 100 together with a series of waveforms 200 summarising the operation of the SMPS. Figure 1 also outlines the main components of the SMPS which includes an input terminal 101 of the SMPS 100 configured to receive an input voltage. The output 112 of the SMPS, as well as various components within the SMPS are also shown in figure 1. In one or more examples the SMPS 100 may include a primary winding 104, a first capacitor 106, a reference terminal 108 that is configured to be coupled to a reference voltage, a secondary winding 110 and an auxiliary winding 114. This fundamental layout of a SMPS will be familiar to those skilled in the art. It will be appreciated that additional components are also included in the SMPS as would be known the person skilled in the art and these are not described here for brevity. Figure 1 also shows a controller 102 which is the focus of this disclosure. Other components such as a high-side 118 and a low-side switching component 120, typically implemented by MOSFETs are also shown in figure 1 but are not described in detail herein as their operation is known to the person skilled in the art.

Returning to the configuration of the windings 104, 110, 114, as shown in figure 1, in one or more examples the primary winding 104 may be configured to receive the input voltage (Vin) at a first terminal of the primary winding 104 and the first capacitor 106 may be coupled in series between a second terminal of the primary winding 104 and the reference terminal 108. In some examples, the secondary winding 110 may be configured to provide an output voltage 112 of the SMPS based on the input voltage received at the input terminal 101 of the SMPS 100. In some examples the output voltage may be based on the turns-ratio between the primary winding 104 and the secondary winding 110. In some examples the auxiliary winding 114 may be configured to provide an auxiliary voltage (Vaux) based at least on the voltage of the first capacitor ($V_{CR}$) 202. In some examples the auxiliary winding 114 may provide a voltage that is based on the inductive coupling between the auxiliary winding 114 and either one or both of the primary winding 104 and secondary winding 110. During the secondary stroke 206 the voltage on the auxiliary winding 114 is representative of the voltage on the first capacitor 106. However, during the primary stroke 204 the voltage on the auxiliary winding may be related to the input voltage (Vin) minus the voltage on the first capacitor 106.

It will be appreciated that the polarity of voltage on the auxiliary winding 114 can be reversed by reversing the polarity of the auxiliary winding. In such a case the voltage on the reversed polarity auxiliary winding may be given by the voltage on the first capacitor 106 minus the input voltage (Vin).

The waveforms 200 of figure 2 show the first capacitor 106 voltage ($V_{CR}$) 202. The primary stroke 204 and secondary stroke 206 of the SMPS 100 are also identified which are realised by control signals 212 which control the switching components 118, 120. Figure 2 also shows the magnetizing current 208 which is the current in the primary winding and the resonant current 210 which is the current through the first capacitor 106. Outside the secondary stroke 206, the magnetizing current 208 and resonant current 210 are the same.

In one or more examples, during the primary stroke 204 the high-side MOSFET 118 is on and the first capacitor 106 is charged. During the primary stroke 204 the low-side MOSFET 120 is off. During the secondary stroke 206, the high-side MOSFET 110 is off and the low-side MOSFET 120 is on. In this case, the energy in the first capacitor 106 is transferred to the secondary side of the SMPS 100. Therefore it is important to monitor the voltage on the first capacitor 106 during the primary stroke 204 to prevent the first capacitor 106 from being charged to above the predetermined maximum capacitor voltage 214 of the first capacitor 106.

During the primary stroke 204, the high side switch 118 of the SMPS 100 is turned on and a current flows from the input 101 of the SMPS 100 to the first capacitor 106. During the primary stroke 204 the first capacitor 106 is charged and its voltage increases. As is known to the skilled person, during the secondary stroke 206, the first capacitor is no longer charged and discharges through the primary winding 104 thereby providing an output voltage at the output 112 of the SMPS 100 through the inductive coupling of the primary winding 104 and the secondary winding 110. The output 112 of the SMPS 100 can be coupled to a load 116 such as a mobile phone, a laptop, a tablet or any other electronic device that requires a regulated voltage.

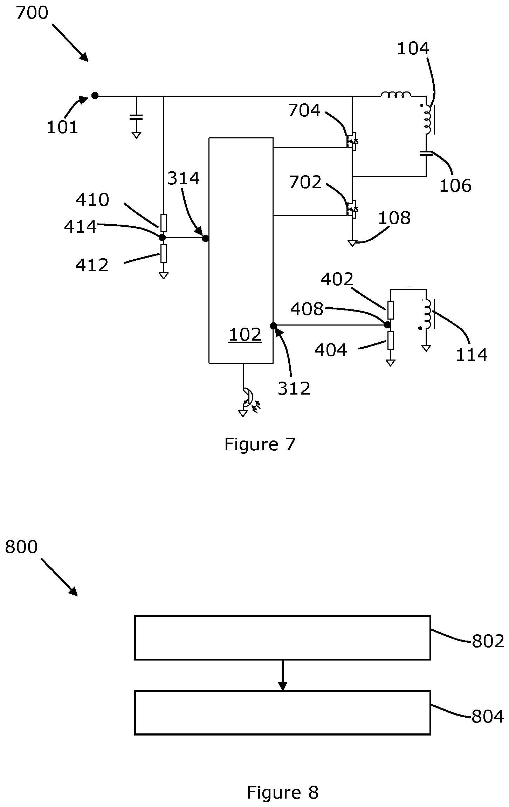

It will be appreciated that the SMPS may typically be configured such that the first capacitor 106 is charged when the high-side switch is on and discharged when the low-side switch is on. However, as shown in figure 7, the SMPS 100 may be configured such that the first capacitor 106 is charged when the low-side switch 702 is on and discharged when the high-side switch 704 is on. In such an example the functionality of the high-side and low-side switches 118, 120 are interchanged compared to that shown in figure 1.

Returning to figure 2, it will be appreciated that the difference between the magnetizing current 208 and resonant current 210 is equal to the reflected output current. So it is clear that energy is only delivered to the secondary side of the SMPS 100 during the secondary stroke 206.

The voltage at the first capacitor 106 is equal to the output voltage times the transformer ratio (which is typically based on the turns ratio between the primary winding 104 and the secondary winding 110) plus some additional ripple voltage. In some examples, if the output voltage is 48V and the transformer ratio is 4, the voltage at the first capacitor can be almost 200V. However this is just one example and the output voltage and the transformer ratio can be defined for the specific application of the SMPS.

To minimize the costs and to cover a wide range of applications, the first capacitor 106 is selected with a maximum rated voltage 214 above the output voltage multiplied by the transformer ratio. In the above example, the first capacitor 106 may therefore be selected with a maximum rated voltage of 250V.

In the event of an error or other fault in the SMPS or if the circuit is not property designed. Or alternatively due to the ageing of components within the SMPS, the voltage on the first capacitor 106 can start to approach or even exceed the maximum rated voltage (e.g. >250V). In this case, the output voltage can damage the device the SMPS is coupled to. It is therefore desirable to have a built in mechanism that can prevent the voltage on the first capacitor 106 from approaching and/or exceeding its maximum rated voltage 214. One major problem is that it is difficult to measure the voltage on the first capacitor 106 in known SMPS designs.

To address the above problem one option could be to include a dedicated pin on the integrated circuit (IC) of the controller 202. However, this introduces manufacturing costs and cannot be applied to existing devices. The approach described herein provides a way to monitor the voltage on the first capacitor 106 and to thereby prevent the voltage of the first capacitor from exceeding a predetermined maximum first capacitor voltage, which may be the maximum rated voltage 214, during the primary stroke 204.

Furthermore, one or more examples of the controller 102 described herein can determine the first capacitor voltage without the need of any additional components and without the need for a dedicated pin on the IC that provides the controller 102.

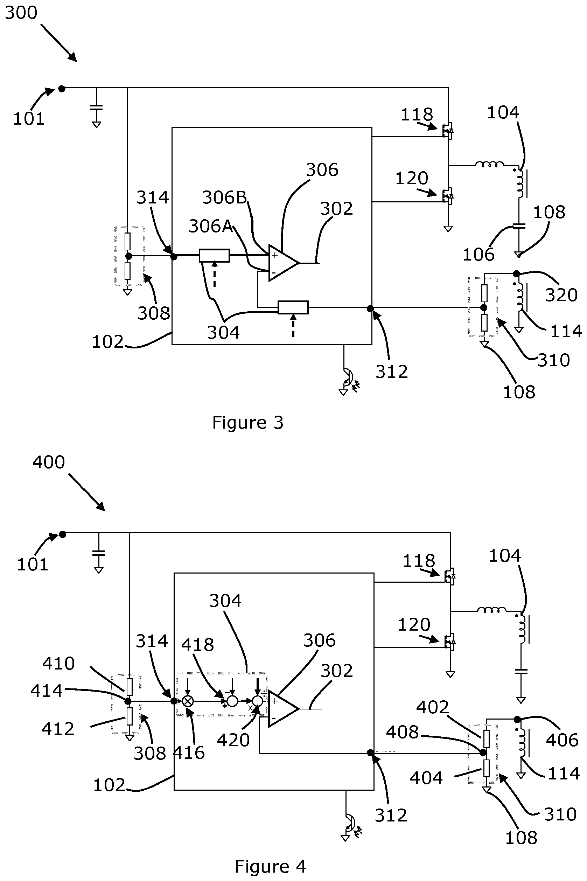

In the example embodiment of figure 1, the controller 102 is configured to output an overvoltage signal (shown as 302 in figure 3) which is indicative of an overvoltage across the first capacitor 106. The overvoltage signal may be based on a comparison of the auxiliary voltage compared to a threshold 214 indicative of a predetermined maximum first capacitor voltage ($V_{CR\_max}$) during a primary stroke 204 of the SMPS 100. In some examples the predetermined maximum first capacitor voltage may be the maximum rated voltage that the first capacitor can be charged to, set by the manufacturer for example. In other examples the predetermined maximum first capacitor voltage may be defined based on operational requirements and may be set to limit the output voltage 112 of the SMPS and based on the intended use of the SMPS 100.

In such an example the predetermined maximum first capacitor voltage may not be the intrinsic maximum voltage of the first capacitor and can be any value up to the maximum rated voltage set for example by the manufacturer of the capacitor. It will be appreciated that as the controller 102 may operate in the digital or analogue domains, the threshold may be a digital value or a voltage that represents the desired predetermined maximum first capacitor voltage.

Figure 3 provides a more detailed view of the controller 102 of the SMPS 100. As mentioned, the controller 102 may be a digital controller and therefore the components shown here may be implemented digitally or, in other examples, it may be an analogue controller with discrete components as shown. In some examples, the controller 102 further includes a comparator 306. The comparator 306 has a inverting input terminal 306A and an non-inverting input terminal 306B306B which are each configured to receive signals to be compared. In one or more examples, it is the comparison of these signals that is indicative of whether the voltage on the first capacitor 106 has exceeded the predetermined maximum first capacitor voltage 214.

It will be appreciated that during the primary stroke 204 the voltage of the first capacitor 106 is related to the input voltage (Vin) minus the auxiliary voltage (Vaux). Therefore, the threshold can be compared against the difference between the input voltage and the auxiliary voltage to determine whether the predetermined maximum first capacitor voltage 214 has been reached. The predetermined maximum first capacitor voltage ($V_{CR\_max}$) can be represented as an analogue signal comprising the predetermined maximum capacitor voltage or a signal representative of the predetermined maximum capacitor voltage or a digital signal representative of the predetermined maximum capacitor voltage. In some examples, where the input voltage is fixed, the threshold indicative of the predetermined maximum capacitor voltage may account for the input voltage such that the threshold can be compared to the auxiliary voltage rather than the threshold being compared against the difference between the input voltage and the auxiliary voltage.

It will be appreciated that if the polarity of the auxiliary winding 114 is reversed, the voltage on the auxiliary winding 114 will be given by the voltage on the first capacitor 106 minus the input voltage (Vin). In such a case, the input to each of the inverting input terminal 306A and the non-inverting input terminal 306B of the comparator 306 will need to be reversed compared to the embodiments shown in figures 3 to 6.

To ensure that the SMPS 100 is protected and to also ensure that the load 116 coupled to the output of the SMPS is protected, the controller 102 can be configured to, in response to the overvoltage signal 302, control the SMPS 100 to stop charging the first capacitor 106. This thereby prevents the voltage of the first capacitor 106 from rising beyond the predetermined maximum capacitor voltage ($V_{CR\_max}$). A further advantage of preventing the voltage of the first capacitor 106 from exceeding the threshold is to ensure continued operation of the SMPS albeit at a lower power.

If the controller 102 does detect that the threshold has been reached, the controller may be configured to adjust the control signals 212 to thereby control the duration of the primary stroke 204 such that during a subsequent primary stroke, the first capacitor 106 is charged for a shorter duration to thereby reduce the likelihood of exceeding the predetermined maximum capacitor voltage. This can improve the longevity of the first capacity and allow for more reliable control of the output voltage 112.

In some examples, the controller 102 may be configured to provide a first switching signal to control the primary stroke of the SMPS during which the first capacitor 106 is charged and may also be configured to provide a second switching signal to control a secondary stroke of the SMPS during which the first capacitor is discharged. It will be appreciated that the first and second switching signals can be used to control the operation of the switching components 118, 120 of the SMPS 102, as will be understood by those skilled in the art.

Figure 3 also shows the components 308, 310 that are used to provide a first voltage and a second voltage to the controller 102. In some examples the first voltage and the second voltage may be provided by voltage dividers 308, 310 and may be configured to provide the voltages on which a first signal and a second signal provided to the comparator 306 are based.

Figure 3 further shows that the controller 102 comprises a first input terminal 314 configured to receive the first voltage. The first voltage may be a voltage that is indicative of the input voltage. In the example of figure 3 the first voltage may be a SNSBOOST voltage. Figure 3 further shows that the controller 102 includes a second input terminal 312 configured to receive a second voltage. The second voltage is indicative of the auxiliary voltage. In the example of figure 3 the second voltage may be the SNSOUT voltage. It will be appreciated that the SNSBOOST and SNSOUT voltage signals are widely used in the field of power supply design and can be generated in various ways. The first voltage and second voltage may be provided by a second voltage divider 308 and a first voltage divider 310 respectively.

In figure 3 the comparator 306 is configured to receive a first signal (e.g. digital SNSBOOST) which is indicative of the first voltage, and to receive a second signal (e.g. digital SNSOUT) which is indicative of the second voltage. It will be appreciated that the digital SNSBOOST and digital SNSOUT signals are digital representations of the SNSBOOST and SNSOUT voltage. The comparator 306 of figure 3 is further configured to output the overvoltage signal 302 which is indicative of an overvoltage across the first capacitor 106. The overvoltage signal 302 may be based on a difference between the second signal and the first signal during the primary stroke 204 of the SMPS 100 compared to the threshold 214 indicative of the predetermined maximum first capacitor voltage ($V_{CR\_max}$).

Figure 3 further shows additional components 304 (or digital processing functions) that can be included in the controller 102 to generate the first and second signals. In some examples the first and second signals can be generated by modifying the first and second voltages. These additional components will be described with relation to figures 4-6.

In figure 4 the second voltage (i.e. SNSOUT) is provided to the controller 102 from the first voltage divider 310 coupled in parallel across the auxiliary winding 114, wherein the first voltage divider 310 comprises a first resistor 402 having a resistance $R_1$ and a second resistor 404 having a resistance $R_2$. A first terminal of the first resistor 402 is coupled to a first terminal 406 of the auxiliary winding 114 and a second terminal of the first resistor is coupled to a first node 408 and a first terminal of the second resistor 404 is coupled to the first node 408 and the second terminal of the second resistor 404 is coupled to the reference terminal 108. The first node 408 may provide the second voltage upon which the second signal is based.

In figure 4 the first voltage (i.e. SNSBOOST) is provided to the controller 102 from the second voltage divider 308 wherein the second voltage is based on the input voltage. The second voltage divider 308 comprises a third resistor 410 having a resistance $R_3$ and a fourth resistor 412 having a resistance $R_4$. A first terminal of the third resistor 410 is coupled to the input terminal a second terminal of the first resistor is coupled to a second node 414 and a first terminal of the fourth resistor 412 is coupled to the second node 414 and the second terminal of the fourth resistor 412 is coupled to the reference terminal 108. The second node 414 may provide the first voltage upon which the first signal is based.

Figure 4 also shows that in some examples, the controller 102 may include a difference element 418, wherein the difference element is configured to generate the first signal (digital SNSBOOST) based on a third signal (multiplied SNSBOOST) that is indicative of the first voltage (SNSBOOST), minus the predetermined maximum first capacitor voltage. In some examples the third signal may be the first voltage modified by a multiplier 416. In some examples the multiplier 416 may be based on the voltage reduction provided by the second voltage divider 308 that provides the first voltage to the controller 102. It will be appreciated that the values of the additional components 304 may be selected based on the values of the resistors of the first and second voltage dividers and more particularly based on the voltage reduction provided by the first and second voltage dividers. This ensures that the first and second signals that are being compared by the comparator 306 are indicative of the input voltage and the auxiliary voltage respectively. This ensures that the compared first and second signals are representative of the voltage on the first capacitor 106.

Figures 4, 5 and 6 show three different arrangements in which either the first voltage or the second voltage or both the first voltage and the second voltage are modified by the additional components 304. In figure 4 it can be seen that the first signal can be derived from the first voltage and may have one or more arithmetic operations performed on the first voltage before being provided to the first input terminal 306A of the comparator 306. In figure 4 the first voltage is coupled from the second node 414 to the first input terminal 314 of the controller 102, and the second voltage is coupled form the first node 408 to the second input terminal 312 of the controller 102.

In one or more examples the first voltage may be a fraction of the input voltage as provided by the second voltage divider 308 and the second voltage may be the a fraction of the auxiliary voltage as provided by the first voltage divider 310.

In figure 4, the first voltage may be multiplied by the multiplier 416 to provide the third signal. In some examples the value of the multiplier 416 is related to the value of the second voltage divider 308 to which it is coupled. The third signal is then reduced by the difference element 418 to reduce the third signal by the predetermined maximum first capacitor voltage ($V_{CR\_max}$) to provide a fourth signal. The fourth signal is then modified by a divider 420 to provide the first signal to the first terminal 306A of the comparator 306. The fourth signal is divided by a factor that corresponds to a ratio of the input voltage to a maximum value set for the second voltage to provide the first signal that is provided to the comparator 306. In some examples the maximum input voltage may be 400V and the maximum value for the second voltage may be set as 10V. However, other values may be used for the input voltage and the maximum value for the second voltage based on circuit constraints. In the above non-limiting example the divider 420 may divide the fourth signal by 40. Although, as mentioned previously other values may be used and are based on the input voltage and the maximum value set for the second voltage.

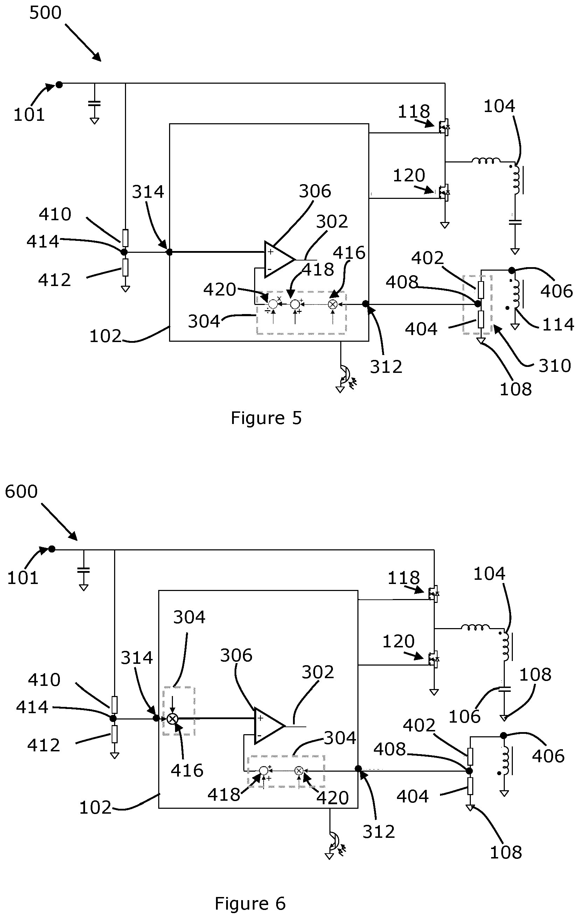

Figure 5 shows an alternative embodiment of the arrangement shown in figure 4. The additional components 304 used in figure 5 perform the opposite operations to those performed in the example of figure 4. In particular the second voltage is first multiplied by a factor (i.e. 40) that corresponds to a ratio of the input voltage to a maximum value set for the second voltage to provide a fifth signal. The fifth signal is then increased by the difference element 418 by the predetermined maximum first capacitor voltage ($V_{CR\_max}$) to provide a sixth signal. The sixth signal is then divided by the multiplier 416 to provide the second signal that is provided to the non-inverting terminal 306B of the comparator. In the example of figure 5 the value of the multiplier 416 is related to the value of the second voltage divider 308 to enable the first and second signals to be compared by the comparator 306.

In figure 6 it can be seen that both the first signal and second signal can be derived from the first voltage and second voltage respectively and can each have one or more arithmetic operations performed before being provided to the first input terminal 306A and the second input terminal 306B of the comparator respectively.

In figure 6 the second voltage is multiplied by the multiplier 416 to provide the third signal as per the example in figure 4. In particular the second voltage is multiplied by the factor that the second voltage divider 308 reduces the input voltage. In figure 6, the second voltage is first multiplied by a factor (i.e. 40) that corresponds to a ratio of the input voltage to a maximum value set for the second voltage to provide a seventh signal. The seventh signal is then increased by the difference element 418 by the predetermined maximum first capacitor voltage ($V_{CR\_max}$) to provide an eighth signal. In the example of figure 6 the signal provided to the non-inverting input terminal 306A of the comparator 306 is the eighth signal and the signal provided to the inverting input 306B of the comparator 306 is the third signal as defined above.

In the examples shown, the additional components 304 apply arithmetic operations to the first and second voltage, however the additional components 304 can also include other operations to modify the first and second voltage to allow for a reliable comparison between the signals by the comparator in order to determine the overvoltage condition on the first capacitor 106. It will also be appreciated that the above arrangements of the additional components 304 are provided to represent the algebraic equations shown below.

In the examples as shown in figures 3-6, it will be appreciated that as the first resistor has a resistance of $R_1$ and the second resistor has a resistance of $R_2$ and the auxiliary voltage being $V_{Aux}$, the second voltage, $V_{second}$ can be represented as follows:

$$V_{second} = \frac{2}{R_1 + R_2} \cdot V_{Aux} \quad (1)$$

The auxiliary voltage ($V_{aux}$) is indicative of the voltage on the first capacitor 106 and, in particular, comprises the difference between the between the input voltage ($V_{IN}$) and the voltage on the first capacitor ($V_{CR}$) multiplied by the turns-ratio $\left(\frac{n_a}{n_p}\right)$ of the auxiliary winding 114 and the primary winding 104. Therefore we can represent equation (1) as follows:

$$V_{second} = \frac{R_2}{R_1 + R_2} \cdot \frac{n_a}{n_p} \cdot (V_{IN} - V_{CR}) \quad (2)$$

It will be appreciated that the turns ratio can also be referred to as the transformer ratio. This is the ratio of the number of turns between any two of the windings, depending on the configuration of the SMPS. The transformer ratio determines the voltage ratio between the primary and the auxiliary winding.

In the examples of figures 3 to 6, it will be appreciated that the third resistor has a resistance of $R_3$ and the fourth resistor has a resistance of $R_4$ and the input voltage has a voltage $V_{IN}$. considering the above the first voltage, $V_{first}$ can be represented as follows:

$$V_{first} = \frac{R_4}{R_3 + R_4} \cdot V_{IN} \quad (3)$$

Using equation 2 and replacing $V_{IN}$ with a rearranged form of equation 3 above leads to:

$$V_{second} = \frac{R_2}{R_1 + R_2} \cdot \frac{n_a}{n_p} \cdot \left(\frac{R_3 + R_4}{R_4} \cdot V_{first} - V_{CR}\right) \quad (4)$$

In some examples, an overvoltage across the first capacitor 106 is determined when the value of the second voltage exceeds a predetermined threshold value, wherein the second voltage that is indicative of an overvoltage condition is given by:

$$V_{second} = \frac{R_2}{R_1 + R_2} \cdot \frac{n_a}{n_p} \cdot \left(\frac{R_3 + R_4}{R_4} \cdot V_{first} - V_{CR\_max}\right) \quad (5)$$

In equation 5, $V_{CR}$ is set as the predetermined maximum first capacitor voltage (i.e. $V_{CR\_max}$). Considering the above, the first signal may be based on a difference between the first voltage and the threshold indicative of the predetermined maximum first capacitor voltage ($V_{CR\_max}$).

When the second voltage exceeds the value determined by the above expression, an overvoltage across the first capacitor 106 can be detected.

In some examples, the maximum value of the second voltage (i.e. SNSOUTMAX) is provided for the largest difference between the input voltage ($V_{IN}$) and the first capacitor voltage ($V_{CR}$). In such a case the maximum value of the second voltage can be provided by the following expression:

$$V_{second\_max} = \frac{R_2}{R_1+R_2} \cdot \frac{n_a}{n_p} \cdot \left(V_{in-max} - V_{CR-min}\right) \ (6)$$

The values of the various additional components 304 can be determined for a specific example as will be summarised below. It will be appreciated that in different configurations the values of the additional components 304 may vary to provide comparable signals to the comparator 306.

In a typical application, there is a fixed relation between $V_{in}$ and $V_{first}$. In most power supplies, power factor correction (PFC) is required before the SMPS converter. The PFC regulates the first voltage to about 2.5V for an input voltage of about 400V. Considering these example values (which are not intended to limit the scope of the application but only to provide a worked example), we can rearrange equation 3 above to give:

$$\frac{R_3 + R_4}{R_4} = \frac{400}{2.5} = 160$$

The maximum input voltage equals the maximum PFC voltage, which in some examples can be 400V. The first capacitor 106 voltage ($V_{CR}$) can have a minimum value of 0V. Therefore, the maximum value for the second voltage (i.e. $V_{second\_max}$) can be realised for the largest difference between $V_{in}$ and $V_{CR}$ (this can be clearly seen in equation 2), this gives:

$$V_{second\_max} = \frac{R_2}{R_1 + R_2} \cdot \frac{n_a}{n_p} \cdot \left(V_{in} - V_{CR}\right) = \frac{R_2}{R_1 + R_2} \cdot \frac{n_a}{n_p} \cdot 400$$

Typically the maximum value for the second voltage (i.e. $V_{second\_max}$) is limited due to circuit constraints and in a typical example can be 10V, although other values can also be used. In this example, taking the above values we get:

$$V_{second\_max} = 10 = \frac{R_2}{R_1 + R_2} \cdot \frac{n_a}{n_p} \cdot 400$$

Re-arranging the formula gives:

$$\frac{R_2}{R_1 + R_2} \cdot \frac{n_a}{n_p} = \frac{10}{400} = \frac{1}{40}$$

therefore for detecting an overvoltage condition, equation 1 can ultimately be written as:

$$V_{Second} = \frac{R_2}{R_1 + R_2} \cdot \frac{n_a}{n_p} \cdot \left(\frac{R_3 + R_4}{R_4} \cdot V_{first} - V_{CR\_max}\right) = \frac{1}{40} \cdot \left(160 \cdot V_{first} - V_{CR\_max}\right)$$

Considering the above, when the second voltage exceeds the value determined by the above expression, it can be interpreted as an overvoltage occurring on the first capacitor 106. $V_{CR\_max}$ is then the maximum allowable voltage on the first capacitor 106. It will be appreciated that $V_{CR\_max}$ can be set to any desired voltage and does not have to be the maximum rated voltage.

It will be appreciated that the above expression can be rearranged whilst allowing the same comparison to be made. The three alternatives are shown below:

$$V_{Second} = \frac{1}{40} \cdot \left(160 \cdot V_{first} - V_{CR\_max}\right),$$

which is the example as depicted in figure 4.

$$40 \cdot V_{Second} = \left(160 \cdot V_{first} - V_{CR\_max}\right),$$

which is the example as depicted in figure 5.

$$40 \cdot V_{Second} + V_{CR\_max} = 160 \cdot V_{first},$$

which is the example as depicted in figure 6.

It will be appreciated that other configurations may also be used and more fewer operations may be performed on the first and second voltages prior to being provided to the comparator 306 and the above are just a few non-limiting examples.

In some examples, the comparator 306 may be configured to compare the second voltage (or a signal based on the second voltage) to the first voltage (or a signal based on the first voltage) to determine when the second voltage exceeds the predetermined maximum first capacitor voltage ($V_{CR\_max}$) or when the second voltage exceeds the value determined by the above expression.

In some cases the comparator 306 can be configured to output the overvoltage signal 302 when the second signal (which is based on the input voltage) is greater than the first signal (which is based on the auxiliary voltage) wherein one of the second signal and the first signal is further based on the predetermined maximum first capacitor voltage ($V_{CR\_max}$).

It will be appreciated in general that the circuitry determines a difference between a signal based on the input voltage and a signal based on the auxiliary voltage that is indicative of the voltage on the first capacitor 106 which can be compared to the threshold indicative of the predetermined maximum capacitor voltage ($V_{CR\_max}$). In the above example the first signal and the second signal are derived such that the overvoltage signal 302 is generated when the second voltage exceeds the predetermined maximum first capacitor voltage ($V_{CR\_max}$). However in other embodiments the polarity of the auxiliary winding may be different and therefore the overvoltage signal 302 is generated when the second voltage falls below the predetermined maximum first capacitor voltage ($V_{CR\_max}$). However, in either embodiment the overvoltage signal 302 indicates an overvoltage condition on the first capacitor 106.

It will be appreciated that the first signal and second signal can be in a different domain, such as in the digital domain. In such a case the first signal can be a digital representation of the first voltage and the second signal can be a digital representation of the second voltage. This allows for the controller to operate in a lower voltage domain whilst controlling the output voltage in a different (usually higher) voltage domain.

The comparator may be configured such that the comparison is made based on the auxiliary voltage present on the auxiliary winding only during the primary stroke. In other examples, the comparison can be made based on the auxiliary voltage present on the auxiliary winding only during the primary stroke and an initial portion of the secondary stroke.

It will be appreciated that the controller 102 can be configured not to output the overvoltage signal 302 during a secondary stroke 206 of the SMPS 100.

While the description above is focussed on the controller 102, we also disclose a SMPS including the controller 102, as shown in Figures 1 and 2 to 7.

It will be appreciated that various types of power supply architecture can be used. In the example shown in figure 1 the SMPS 102 comprises an asymmetric half bridge (AHB) topology.

Figure 8 outlines an example method of controlling a SMPS 100. The method includes comparing 802, by a controller of the SMPS, the auxiliary voltage during a primary stroke of the SMPS to a threshold indicative of a predetermined maximum first capacitor voltage (Vcrmax). The method further includes outputting 804 by the controller of the SMPS, an overvoltage signal indicative of an overvoltage across the first capacitor based on said comparison.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

**Claims**

1. A controller for a switched mode power supply, SMPS, the SMPS comprising a primary winding configured to receive an input voltage at a first terminal of the primary winding; a first capacitor coupled in series between a second terminal of the primary winding and a reference terminal configured to be coupled to a reference voltage; and a secondary winding configured to provide an output voltage of the SMPS based on the input voltage; and an auxiliary winding inductively coupled to one or both of the primary winding and the secondary winding and configured to provide an auxiliary voltage based at least on a voltage of the first capacitor;

   wherein the controller is configured to output an overvoltage signal indicative of an overvoltage across the first capacitor, based on a comparison of the auxiliary voltage during a primary stroke of the SMPS to a threshold indicative of a predetermined maximum first capacitor voltage.

2. The controller of claim 1, wherein said comparison comprises a comparison between the threshold and a difference between the input voltage and the auxiliary voltage.

3. The controller of any preceding claim, wherein the controller is configured to, in response to the overvoltage signal, control the SMPS to stop charging the first capacitor.

4. The controller of claim 3, wherein the controller is thereby configured to control the duration for which the first capacitor is charged during each primary stroke based at least in part on the overvoltage signal

5. The controller of any preceding claim, wherein the controller comprises:

   a first input terminal configured to receive a first voltage indicative of the input voltage;
   a second input terminal configured to receive a second voltage indicative of the auxiliary voltage; and
   a comparator configured to receive a first signal indicative of the first voltage, and a second signal indicative of the second voltage, wherein the comparator is further configured to output the overvoltage signal indicative of an overvoltage across the first capacitor based on the second signal during the primary stroke of the SMPS and the first signal and the threshold indicative of the predetermined maximum first capacitor voltage.

6. The controller of claim 5, wherein the first signal is based on a difference between the first voltage and the threshold indicative of the predetermined maximum first capacitor voltage.

7. The controller of claim 5 or 6, wherein the comparator is configured to output the overvoltage signal when the second signal is exceeds the first signal.

8. The controller of any preceding claim, wherein the controller is configured to, in response to the output of the overvoltage signal, shorten the duration of the primary stroke to thereby limit the voltage to which the first capacitor is charged during one or more subsequent primary strokes of the SMPS.

9. The controller of any of claims 5 to 8, wherein the controller includes a difference element, wherein the difference element is configured to generate the first signal based on a third signal that is indicative of the first voltage minus the predetermined maximum first capacitor voltage.

10. The controller of any of claims 5 to 9, wherein the controller is configured to receive the second voltage from a first voltage divider coupled in parallel across the auxiliary winding, wherein the first voltage divider comprises a first resistor having a resistance $R_1$ and a second resistor having a resistance $R_2$, wherein a first terminal of the first resistor is coupled to a first terminal of the auxiliary winding and a second terminal of the first resistor is coupled to a first node and a first terminal of the second resistor is coupled to the first node and wherein the second terminal of the second resistor is coupled to the reference terminal, and wherein the first node provides the second voltage upon which the second signal is based.

11. The controller of any of claims 5 to 10, wherein the controller is configured to receive the first voltage (*SNSBOOST*) from a second voltage divider comprising:
a third resistor and a fourth resistor, wherein a first terminal of the third resistor is configured to receive the input voltage and a second terminal of the third resistor is coupled to a second node and a first terminal of the fourth resistor is coupled to the second node and wherein the second terminal of the fourth resistor is coupled to the reference terminal, and wherein the second node provides the first voltage upon which the first signal is based.

12. The controller of any preceding claim, wherein the controller is configured to provide a first switching signal to control the primary stroke of the SMPS during which the first capacitor is charged and a second switching signal to control a secondary stroke of the SMPS during which the first capacitor is discharged.

13. A switched mode power supply, SMPS, comprising the controller of any preceding claim, the SMPS comprising:

    the primary winding configured to receive an input voltage at the first terminal of the primary winding; and
    the first capacitor coupled in series between the second terminal of the primary winding and the reference terminal;
    the secondary winding configured to provide an output voltage of the SMPS based on the input voltage; and
    the auxiliary winding configured to provide an auxiliary voltage based at least on the first capacitor voltage.

14. The switched mode power supply of claim 13, wherein the auxiliary winding is inductively coupled to one or both of the primary winding and the secondary winding such that during the primary stroke of the SMPS, the auxiliary voltage is based on the input voltage minus the voltage on the first capacitor.

15. A method for controlling a switched mode power supply, SMPS, the SMPS comprising a primary winding configured to receive an input voltage at a first terminal of the primary winding; a first capacitor coupled in series between a second terminal of the primary winding and a reference terminal configured to be coupled to a reference voltage; and a secondary winding configured to provide an output voltage of the SMPS based on the input voltage; and an auxiliary winding inductively coupled to one or both of the primary winding and the secondary winding and configured to provide an auxiliary voltage based at least on a voltage of the first capacitor;
the method comprising:

    comparing, by a controller of the SMPS, the auxiliary voltage during a primary stroke of the SMPS to a threshold indicative of a predetermined maximum first capacitor voltage; and
    outputting by the controller of the SMPS, an overvoltage signal indicative of an overvoltage across the first capacitor based on said comparison.

Figure 1

Figure 2

Figure 3

Figure 4

Figure 5

Figure 6

Figure 7

Figure 8

Europäisches
Patentamt

European
Patent Office

Office européen
des brevets

# EUROPEAN SEARCH REPORT

Application Number

EP 23 19 6322

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>A | US 2014/313787 A1 (CHEN JIAN [JP]) 23 October 2014 (2014-10-23) * abstract * * paragraphs [0033], [0037] - [0039], [0044], [0045]; figures 1-8 * | 1-4,8, 12-15<br>5-7,9-11 | INV.<br>H02M1/32<br>H02M3/00<br>H02M3/335 |
| A | US 10 855 189 B2 (FUJI ELECTRIC CO LTD [JP]) 1 December 2020 (2020-12-01) * abstract * * column 6, line 38 - column 7, line 19 * | 1-15 | |

TECHNICAL FIELDS
SEARCHED      (IPC)

H02M

The present search report has been drawn up for all claims

| Place of search | Date of completion of the search | Examiner |
|---|---|---|
| The Hague | 24 January 2024 | Van der Meer, Paul |

EPO FORM 1503 03.82 (P04C01)

## ANNEX TO THE EUROPEAN SEARCH REPORT
## ON EUROPEAN PATENT APPLICATION NO.

**EP 23 19 6322**

This annex lists the patent family members relating to the patent documents cited in the above-mentioned European search report.
The members are as contained in the European Patent Office EDP file on
The European Patent Office is in no way liable for these particulars which are merely given for the purpose of information.

**24-01-2024**

| Patent document cited in search report | | Publication date | Patent family member(s) | | Publication date |
|---|---|---|---|---|---|
| US 2014313787 | A1 | 23-10-2014 | CN | 104113216 A | 22-10-2014 |
| | | | JP | 6135271 B2 | 31-05-2017 |
| | | | JP | 2014212642 A | 13-11-2014 |
| | | | US | 2014313787 A1 | 23-10-2014 |
| US 10855189 | B2 | 01-12-2020 | CN | 111052581 A | 21-04-2020 |
| | | | JP | 6849143 B2 | 24-03-2021 |
| | | | JP | WO2019181181 A1 | 22-10-2020 |
| | | | US | 2020195151 A1 | 18-06-2020 |
| | | | WO | 2019181181 A1 | 26-09-2019 |

EPO FORM P0459

For more details about this annex : see Official Journal of the European Patent Office, No. 12/82